Europäisches Patentamt

European Patent Office

Office européen des brevets

(11) Veröffentlichungsnummer: **0 293 495**
A1

## (12) EUROPÄISCHE PATENTANMELDUNG

Veröffentlicht nach Art. 158 Abs. 3 EPÜ

(21) Anmeldenummer: 88900608.6

(22) Anmeldetag: 14.12.87

Daten der zugrundeliegenden internationalen Anmeldung:

(86) Internationale Anmeldenummer:
PCT/SU87/00142

(87) Internationale Veröffentlichungsnummer:
WO88/04827 (30.06.88 88/14)

(51) Int. Cl.³: **G 11 C 11/42**

(30) Priorität: 15.12.86 SU 4157162

(43) Veröffentlichungstag der Anmeldung:
07.12.88 Patentblatt 88/49

(84) Benannte Vertragsstaaten:
AT BE CH DE FR GB IT LI LU NL SE

(71) Anmelder: INSTITUT PROBLEM MODELIROVANIA V
ENERGETIKE AKADEMII NAUK UKRAINSKOI SSR
pr. Pobedy, 56
Kiev, 252680(SU)

(72) Erfinder: ANTONOV, Alexandr Alexandrovich
pr. Vernadskogo, 85/64
Kiev, 252142(SU)

(72) Erfinder: PETROV, Vyacheslav Vasilievich
ul. Montazhnikov, 104
Kiev, 252069(SU)

(74) Vertreter: Füchsle, Klaus, Dipl.-Ing. et al,
Hoffmann . Eitle & Partner Patentanwälte Arabellastrasse
4
D-8000 München 81(DE)

(54) OPTISCHE SPEICHERVORRICHTUNG.

(57) An optical memorizing device comprises storage (7) for
optical information carriers (6), a mechanism (8) for moving
them from the storage (7) to one or several positions (4) for
recording or reading the information, a source (1) of modulated electromagnetic radiation and photoreceptors (3) optically connected with the carriers (6), as well as a unit (2) for
switching the modulated electromagnetic radiation from the
source (1) to the optical carriers and from the carriers (6) to
the photoreceptors (3), depending on the address of the position (4) at which a corresponding carrier is situated.

FIG. 1

OPTISCHER SPEICHER

### Gebiet der Technik

Die Erfindung bezieht sich auf Mittel zum Aufzeichnen und Auslesen von Informationen und betrifft insbesondere optische Speicher.

### Stand der Technik

Es ist ein optischer Speicher bekannt, der eine Quelle einer modulierten elektromagnetischen Strahlung (aus einem Gaslaser), einen Fotoempfänger, eine Arbeitsstellung für einen optischen Plattendatenträger sowie eine Bibliothek für optische Plattendatenträger und eine Baugruppe für deren Beförderung in die Arbeitsstellungen und zurück enthält. Die Verwendung des optischen Plattendatenträgers ermöglicht einen Direktzugriff zu den Informationen und gestattet es dadurch, die Zugriffszeit zu den Informationen einigermaßen zu verringern (EP,B, 0106570).

Nachteil derartiger Lösung bleibt eine recht lange Zugriffszeit, die die Zeit für Beförderung, Anlauf, Anhalten und Abnahme eines optischen Plattendatenträgers umfaßt. Anderer Nachteil ist eine niedrige Zuverlässigkeit beim Aufzeichnen/Auslesen, da in der Arbeitsstellung nur ein optischer Kopf zur Verfügung steht, bei dessen Ausfall das Aufzeichnen/Auslesen nicht möglich wird.

Es ist ein optischer Speicher bekannt, der optisch gekoppelt Quellen einer modulierten elektromagnetischen Strahlung aus Laserdioden, Fotoempfänger und sechzehn Arbeitsstellungen für optische Banddatenträger, die in hermetisch abschlossenen Kassetten mit einer Informationskapazität zu je 6 GByte angeordnet sind, sowie eine Bibliothek für Banddatenträger und eine Baugruppe für deren Beförderung in die Arbeitsstellungen und zurück enthält (Mini-Micro Systems, June, 1984 Keith Jones "DOC data plans to make 6,000 M-byte optical-type cassette", S. 98,101.

- 2 -

In diesem Speicher beträgt die Zugriffszeit zu den Informationen 1 bis 10 s und ist durch eine sequentielle Art des Zugriffs zu den Informationen auf dem Banddatenträger bedingt. Anderer Nachteil ist eine niedrige Zuverlässigkeit beim Aufzeichnen/ Auslesen, da in jeder Arbeitsstellung für den Datenträger nur ein optischer Kopf zur Verfügung steht, bei dessen Ausfall das Aufzeichnen/Auslesen nicht möglich wird.

Offenbarung der Entindung

Der Erfindung liegt die Aufgabe zugrunde, einen optischen Speicher zu schaffen, der es gestattet, durch Änderung der Reihenfolge und der zeitlichen Überlappung von einzelnen Operationen des Vorganges der Organisation des Zugriffs auf zu schreibende oder auszulesende Informationen die Zugriffszeit zu den Informationen zu verkürzen.

Diese Aufgabe wird dadurch gelöst, daß der optische Speicher, bei dem in einer oder mehreren, mindestens zwei, Stellungen ein beweglicher optischer Datenträger mittels einer Verschiebevorrichtung zum Holen des optischen Trägers aus einem Archiv angeordnet ist, der mit mindestens einer Quelle einer modulierten elektromagnetischen Strahlung und mit mindestens einem Fotoempfänger otpisch gekoppelt ist, gemäß der Erfindung eine Einheit zur Umschaltung der modulierten elektromagnetischen Strahlung von der Quelle einer modulierten elektromagnetischen Strahlung auf die optischen Datenträger und von den optischen Datenträgern auf den Fotoempfänger in Abhängigkeit von der Adresse der Stellung, in der der entsprechende optische Datenträger angeordnet ist, enthält.

Die Einheit zur Umschaltung der modulierten elektromagnetischen Strahlung kann optisch gekoppelt - einen in einem gleichen Abstand von den optischen Datenträgern bei deren Anordnung in einer entsprechenden Stellung liegenden Lichtteiler und eine drehbar samt dem Lichtteiler ausgeführte Linse aufweisen.

Bei der zylindrischen Ausführung des um seine Achse rotierenden optischen Datenträgers ist es zweckmäßig, daß die Drehachse des Lichtteilers parallel zur Drehachse des zylindrischen optischen Datenträgers verläuft.

Diese Ausführung des optischen Speichers erhöht die Zuverlässigkeit beim Aufzeichnen und Auslesen von Informationen und verringert die Zugriffszeit zu diesen.

Die Erfindung soll im weiteren durch die nachstehende Beschreibung von Ausführungsbeispielen anhand der beiliegenden Zeichnungen näher erläutert werden. Es zeigt:

Fig. 1 ein Funktionsschaltbild eines erfindungsgemäßen optischen Datenspeichers;

Fig. 2 ein Funktionsschaltbild eines anderen erfindungsgemäßen optischen Speichers;

Fig. 3 eine erfindungsgemäße Umschalteinheit;

Fig. 4 eine gegenseitige räumliche Anordnung von erfindungsgemäßen drehbaren Lichtteilern und optischen Datenträgern in entsprechenden Stellungen;

Fig. 5 ein anderes Beispiel der gegenseitigen räumlichen Anordnung der drehbaren Lichtteiler und optischen Datenträger in den entsprechenden Stellungen.

### Bevorzugte Ausführungsform der Erfindung

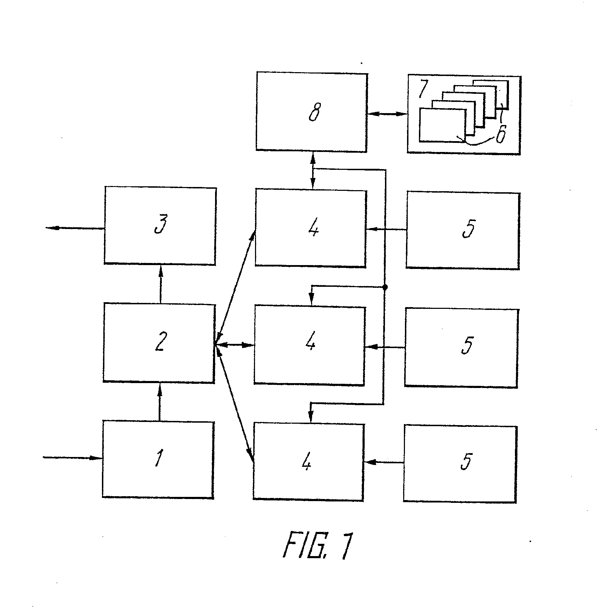

Der optische Speicher enthält-optisch gekoppelt - eine Quelle 1 (Fig. 1) einer modulierten elektromagnetischen Strahlung, beispielsweise einen Festkörper- oder Gaslaser mit einem optischen Modulator oder

- 4 -

einen Halbleiterlaser mit einer steuerbaren Speisequelle, eine Einheit 2 zur Umschaltung der modulierten elektromagnetischen Strahlung von der Quelle 1 einer modulierten elektromagnetischen Strahlung auf optische Datenträger und von diesen auf einen Fotoempfänger 3 in Abhängigkeit von der Adresse von Stellungen 4, in denen Positionierer 5 liegen, die für die Adressierung der modulierten elektromagnetischen Strahlung sorgen, und optische Datenträger 6, beispielsweise röhrenförmige, Platten-, Banddatenträger u.a.

Der Fotoempfänger 3 wird in bekannter Weise hergestellt und kann mindestens eine Fotodiode und einen Verstärrer enthalten.

Darüber hinaus weist der optische Speicher einen Archiv 7 für optische Datenträger 6 und eine Verschiebevorrichtung 8 für deren Übertragung in die Stellungen 4 und zurück auf. Als Vorrichtung 8 kann ein Handhabungsroboter beliebiger bekannter Konstruktion eingesetzt werden.

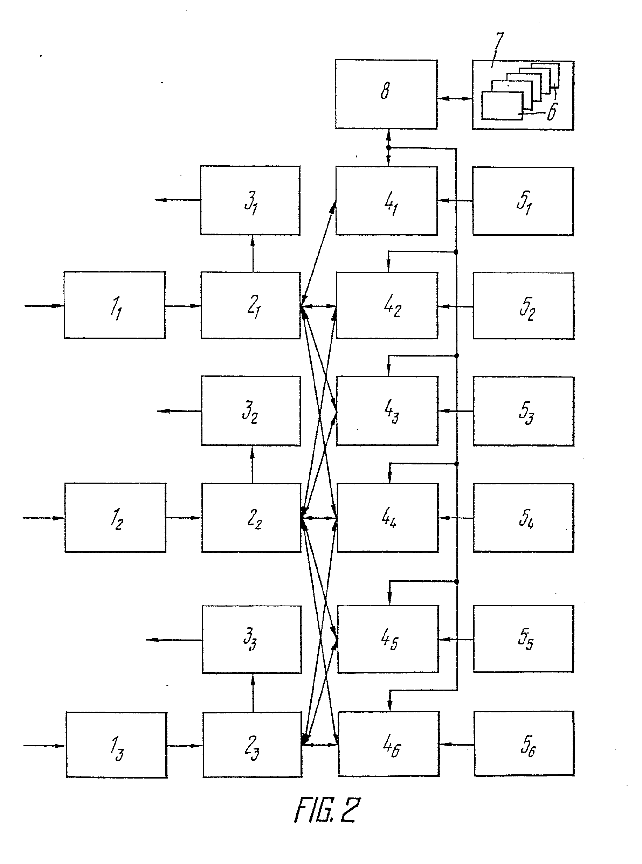

Der in Fig. 2 dargestellte optische Speicher enthält drei Quellen $1_1$, $1_2$, $1_3$ einer modulierten elektromagnetischen Strahlung und drei jeweilige Einheiten $2_1$, $2_2$, $2_3$ zur Umschaltung der modulierten elektrokmagnetischen Strahlung von der Quelle 1 einer modulierten elektromagnetischen Strahlung auf die optischen Datenträger 6 und von den optischen Datenträgern 6 auf jeweilige Fotoempfänger $3_1$, $3_2$, $3_3$. Er weist sechs Stellungen $4_1$, $4_2$, $4_3$, $4_4$, $4_5$, $4_6$ für die Anordnung der optischen Datenträger 6 während der Aufzeichnung der Informationen auf diesen und der Ablesung der Informationen von diesen auf. Hierbei erreicht die modulierte elektromagnetische Strahlung die einzelnen Stellungen $4_1$, $4_2$, $4_3$, $4_4$, $4_5$, $4_6$ von mehr als einer Quelle 1 einer modulierten elektromagnetischen Strahlung auf, d.h. die Strahlung

erreicht die Stellungen $4_2$, $4_3$ von den Quellen $2_1$ und $2_2$ , die Stellung $4_4$ von den Quellen $2_1$, $2_2$ und $2_3$, die Stellungen $4_5$, $4_6$ von den Quellen $2_2$ und $2_3$. Jeder Stellung $4_1$ bis $4_6$ ist ihr eigener Positionierer $5_1$, $5_2$, $5_3$, $5_4$, $5_5$, $5_6$ zugeordnet.

Die Datenträger 6 werden vom Archiv 7 in die Stellungen 4 und zurück durch die Verschiebevorrichtung 8 übertragen.

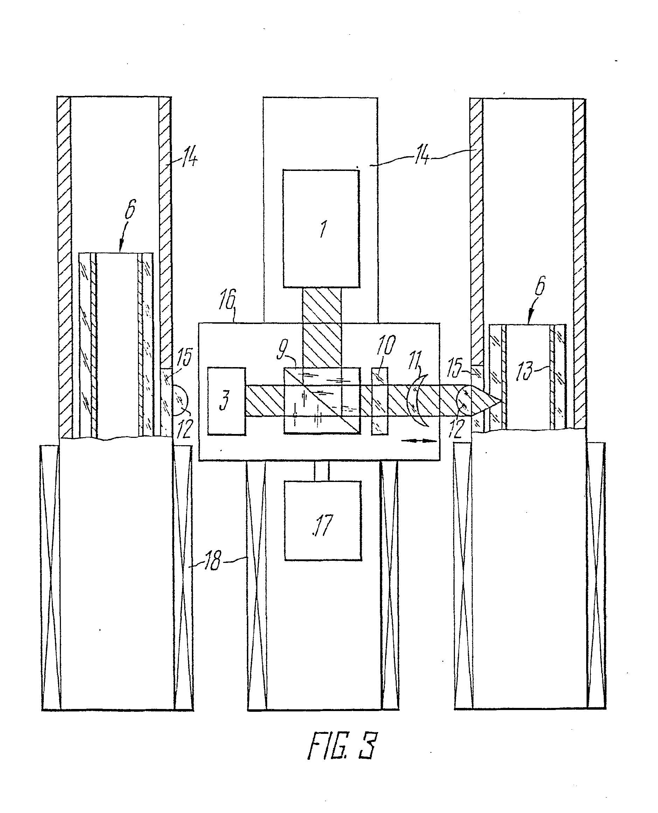

Die in Fig. 3 dargestellte Einheit 2 zur Umschaltung der modulierten elektromagnetischen Strahlung enthält einen drehbaren Lichtteiler 9, dessen optischer Eingang mit der Quelle 1 einer modulierten elektromagnetischen Strahlung verbunden ist, deren optischer Ausgang über eine Viertelwellenplatte 10, eine bewegliche Linse 11 und eine unbewegliche Linse 12 mit der Aufzeichnungsschicht 13 eines zylindrischen Datenträgers 6 optisch gekoppelt ist. Der Träger 6 ist in einem Behälter 14 mit einem transparenten Fenster 15 eingeschlossen. Der andere optische Ausgang des drehbaren Lichtteilers 9 ist mit dem Fotoempfänger 3 verbunden. Die aufgezählten Baugruppen 9, 10, 11 und 3 sind auf einer Grundlage 16 angeordnet, die mit der Achse eines Elektromotors 17 kinematisch verbunden ist, mit dessen Hilfe die Grundlage 16 um die vertikale Achse des drehbaren Lichtteilers 9 in Rotation versetzt wird. Durch die Verschiebevorichtung 8 (Fig. 1, 2) werden die zylindrischen optischen Datenträger 6 in den Innenraum der Behälter 14 eingebracht und mit Hilfe von Elektromotoren 18 in Drehung um ihre Achse versetzt sowie in Achsrichtung zwecks Positionierung bewegt.

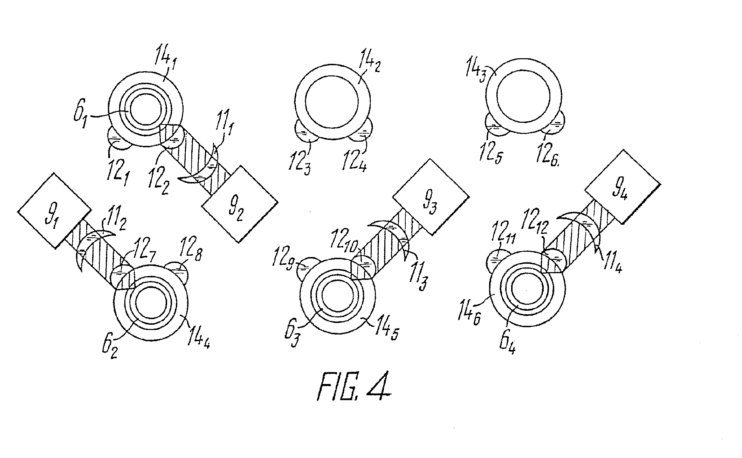

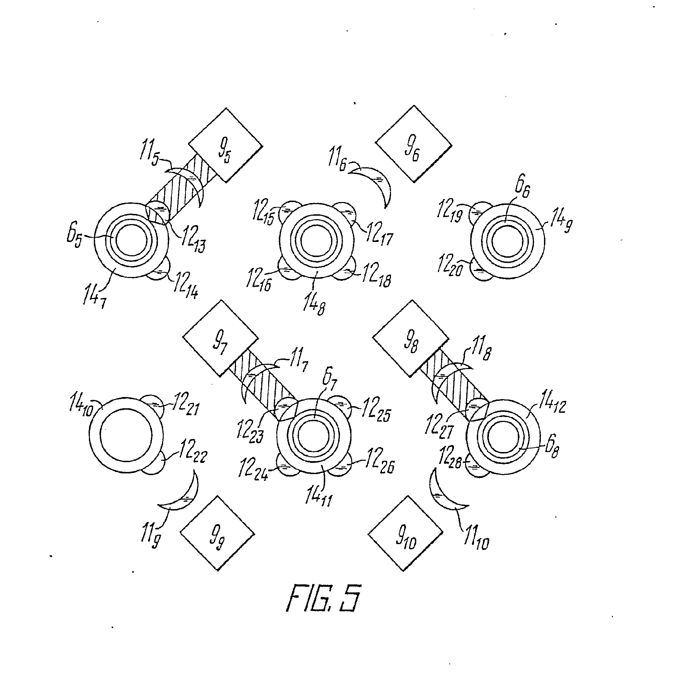

Fig. 4 und 5 zeigen in Draufsicht mögliche Varianten einer gegenseitigen Anordnung der drehbaren Lichtteiler 9 bezüglich der zylindrischen optischen Datenträger 6, die in den Behältern 14 untergebracht sind. So liegen die drehbaren Lichtteiler $9_1$, $9_2$, $9_3$ und $9_4$ in Fig. 4 in einem gleichen Abstand von den Behältern $14_1$, $14_2$, $14_3$, $14_4$, $14_5$ und $14_6$, in manchen von denen die zylindrischen optischen Datenträger $6_1$ bis $6_4$ untergebracht sind. Der zylindrische Datenträger $6_1$ ist im Behälter 14, der Träger $6_2$ im Behälter $14_4$, der Träger $6_3$ im Behälter $14_5$ und der Träger $6_4$ im Behälter $14_6$ untergebracht. Allen aufgezählten zylindrischen optischen Trägern $6_1$, $6_2$, $6_3$, $6_4$ wird die elektromagnetische Strahlung über entsprechende bewegliche Linsen $11_1$, $11_2$, $11_3$ und $11_4$ und unbewegliche Linsen $12_1$, $12_2$, $12_3$, $12_4$, $12_5$, $12_6$, $12_7$, $12_8$, $12_9$, $12_{10}$, $12_{11}$ und $12_{12}$ von den Ausgängen der jeweiligen drehbaren Lichtteiler 9 zugeführt. Dem zylindrischen optischen Träger $6_1$ wird also die elektromagnetische Strahlung vom Ausgang des drehbaren Lichtteilers $9_2$ über die bewegliche Linse $11_1$ und die unbewegliche Linse $12_2$, dem Träger $6_2$ vom Ausgang des drehbaren Lichtteilers $9_1$ über die bewegliche Linse $11_2$ und die unbewegliche Linse $12_7$, dem Träger $6_3$ vom Ausgang des drehbaren Lichtteilers $9_3$ über die bewegliche Linse $11_3$ und die unbewegliche Linse $12_{10}$, dem Träger $6_4$ vom Ausgang des drehbaren Lichtteilers $9_4$ über die bewegliche Linse $11_4$ und die unbewegliche Linse $12_{12}$ zugeleitet. In der Behältern $14_2$ und $14_3$ gibt es keine zylindrischen optischen Datenträger 6, und ihnen wird daher keine elektromagnetische Strahlung zugeführt. In Fig. 4 sind an jedem Behälter 14 je zwei unbewegliche Linsen 12 angebracht, weshalb dem in diesen untergebrachten zylindrischen optischen Datenträger 6 die elektromagnetische Strahlung vom Ausgang eines beliebigen der zwei nebeneinander angeordneten drehbaren Lichtteiler 9 zugeführt wird, wie dies vorstehend angegeben ist.

Der in Fig. 5 dargestellte optische Speicher enthält sechs Behälter $14_7$, $14_8$, $14_9$, $14_{10}$, $14_{11}$,

$14_{12}$ und sechs drehbare Lichtteiler $9_5$, $9_6$, $9_7$, $9_8$, $9_9$, $9_{10}$, mit drehbaren Linsen $11_5$, $11_6$, $11_7$, $11_8$, $11_9$, $11_{10}$. Än den Behältern $14_7$, $14_9$, $14_{10}$, $14_{12}$ sind je zwei unbewegliche Linsen 12 ($12_{13}$, $12_{14}$, $12_{19}$, $12_{20}$, $12_{21}$, $12_{22}$, $12_{27}$, $12_{28}$) und an den Behältern $14_8$ und $14_{11}$ je vier unbewegliche Linsen 12 ($12_{15}$, $12_{16}$, $12_{17}$, $12_{18}$, $12_{23}$, $12_{24}$, $12_{25}$, $12_{26}$) angeordnet. Dem im Behälter $14_7$ untergebrachten zylindrischen optischen Datenträger $6_5$ kann daher die elektromagnetische Strahlung vom beliebigen der drehbaren Lichtteiler $9_5$, $9_7$, dem im Behälter $14_8$ untergebrachten Träger 6 (Fig. 5, 9) von den drehbaren Lichtteilern $9_5$, $9_6$, $9_7$, $9_8$ , dem im Behälter $14_9$ untergebrachten Träger $6_6$ von den drehbaren Lichtteilern $9_6$, $9_8$, dem im Behälter $14_{10}$ untergebrachten Träger 6 (Fig. 5, 2) von den drehbaren Lichtteilern $9_7$, $9_9$, dem im Behälter $14_{11}$ untergebrachten Träger $6_7$ von den drehbaren Lichtteilern $9_7$, $9_8$, $9_9$, $9_{10}$ und dem im Behälter $14_{12}$ untergebrachten Träger $6_8$ von den drehbaren Lichtteilern $9_8$, $9_{10}$ zugeführt werden. In Fig. 5 ist es aber als eines der möglichen Beispiele gezeigt, daß die elektromagnetische Strahlung dem zylindrischen optischen Datenträger $6_5$ vom drehbaren Lichtteiler $9_5$ , dem zylindrischen optischen Datenträger $6_7$ vom drehbaren Lichtteiler $9_7$, dem zylindrischen optischen Datenträger $6_8$ vom drehbaren Lichtteiler $9_8$ zugeleitet wird . Dem im Behälter $14_9$ befindlichen zylindrischen optischen Datenträger $6_6$ wird keine Strahlung zugeführt, d.h. er ist auf die Verarbeitung entweder nur vorbereitet oder er ist bereits verarbeitet worden und ist in den Archiv 7 (Fig. 1, 2) abzutransportieren.

0293495

Es sind auch andere Realisierungsvarianten des angemeldeten optischen Speichers denkbar, die sich durch die Art des verwendeten optischen Datenträgers, durch die gegenseitige Anordnung der Einheiten zur Umschaltung der modulierten elektromagnetischem Strahlung und der optischen Datenträger, durch eine andere Ausführung der Einheit zur Umschaltung der modulierten elektromagnetischen Strahlung und andere Einzelheiten unterscheiden, die es gestatten, die gestellte Aufgabe zu lösen, ohne daß vom Umfang und Wesen der vorliegenden Erfindung abgewichen wird.

Der optische Speicher arbeitet wie folgt.

Im Schreibbetrieb wird die Strahlung der Quellen 1 einer elektromagnetischen Strahlung unter der Wirkung des aufzuzeichnenden Signals intensitäts- oder irgendwie anders moduliert. Mit Hilfe der Einheit 2 zur Umschaltung der modulierten elektromagnetischen Strahlung wird diese Strahlung auf den in der Arbeitsstellung 4 befindlichen optischen Datenträger 6 gerichtet, der vorhin auf die Betrriebsdrehzahl gebracht und durch den Positionierer 5 bezüglich des Strahls nach der vorgegebenen Adresse positioniert ist. Zur selben Zeit werden die optischen Datenträger 6 nach deren Anhalten aus den anderen Stellungen 4 durch die Verschiebevorrichtung 8 in den Archiv 7 für optische Datenträger 6 abtransportiert, während in die Stellungen 4 aus dem Archiv 7 andere auf die Aufnahme/Wiedergabe von Informationen vorbereitete optische Träger geholt werden. Im angemeldeten Speicher wird die Zugriffszeit daher nur durch die Schaltzeit der Einhet 2 zur Umschaltung der modulierten elektromagnetischen Strahlung festgelegt.

Im optischen Speicher wird die Möglichkeit (Fig. 2, 4, 5,) einer gemeinsamen Arbeit der in den Stellungen 4 stehenden optischen Datenträger 6 mit den verschiedenen Quellen 1 einer modulierten elektro_
magnetischen Strahlung vorgesehen. Diesen Möglich_
keit (Fig. 4, 5) wird durch Montage von mehreren
mit den Ausgängen mancher Einheiten 2 zur Umschal_
tung der modulierten elektromagnetischen Strah_
lung optisch gekoppelten unbeweglichen Linsen 12
in den transparenten Fenstern 15 des Behälters 14
für den in der Stellung 4 befindlichen Datenträger 4
realisiert. Infolgedessen können die Funktionen
beispielsweise irgendwelcher Quelle 1 einer modu_
lierten elektromagnetischen Strahlung oder irgend_
welcher Einheit 2 zur Umschaltung der modulierten
elektromagnetischen Strahlung bei deren Ausfall
durch einen anderen mit der gleichen Stellung ge_
koppelten optischen Kanal übernommen werden, was es
gestattet, die Betriebszuverlässigkeit des Speichers
wesentlich zu erhöhen.

Im Lesebetrieb strahlt die Quelle 1 einer modu_
lierten elektromagnetischen Strahlung einen Strahl
konstanter Intensität aus, der in der Stellung 3
durch die auf dem Träger 6 aufgezeichnete Informa_
tion intensitätsmoduliert wird. Im Fotoempfänger 3
wird das optische Signal in ein elektrisches
Wiedergabesignal verwandelt.

Die in Fig. 3 dargestellte Einheit 2 einer modu_
lierten elektromagnetischen Strahlung arbeitet wie
folgt.

Der durch die Quelle 1 einer modulierten elektro_
magnetischen Strahlung ausgesandte im Schreibbetrieb
modulierte und im Lesebetrieb nicht modulierte Strahl
wird mit Hilfe des durch den Elektromotor 17 gedrehten
drehbaren Lichtteilers 9 auf diese oder jene Stellung
ausgerichtet, in der ein rotierender und positionierter
zylindrischer Datenträger 6 angeordnet ist. Der vom
drehbaren Lichtteiler 9 reflektierte Strahl passiert
dabei die Viertelwellenplatte 10, die bewegliche Linse 11, mit deren Hilfe dessen Selbstfokussierung erfolgt, un die unbewegliche Linse 12, die im transparenten Fenster 15 des Gehäuses des Behälters 14 montiert ist, in dem der bewegliche zylindrische optische Datenträger 6 untergebracht ist. Dessen Drehen und Positionieren durch eine axiale Verschiebung werden mit Hilfe eines elektrischen Zweikoordinatenmotors 18 erreicht. Der vom beweglichen zylindrischen optischen Trager 6 reflektierte Strahl , indem er die Viertelwellenplatte 10 zum zweitenmal passiert, dreht seine Polarisationselbene im Endeffekt bezüglich der ursprünglichen Richtung um 90°, weshalb er durch den drehbaren Lichteiler 9 zum Fotoempfänger 3 gelangt.

Es sind auch andere Realisierungen des angemeldeten Speichers möglich, die sich durch die Anzahl von mit den Arbeitsstellungen gekoppelten optischen Köpfen, die Varianten der Kopplung, die Art des verwendeten optisch steuerbaren Schalters und andere Besonderheiten unterscheiden.

Der behandelte optische Speicher weist eine geringe Zugriffszeit von ca 1 s bei einer Speicherkapazität der zylindris.chen optischen Datenträger von 200 bis 500 MByte auf. Die Betriebszuverlässigkeit des Speichers wird durch Ermöglichung der Benutzung von optischen Reservekanälen zum Lesen bzw. Schreiben von Informationen erhöht.

### Gewerbliche Anwendbarkeit

Die Erfindung kann als Externspeicher von elektronischen Rechnern, nämlich bei der Organisation von Datenbänken, angewendet werden.

- 11 -

## PATENTANSPRÜCHE

1 Optischer Speicher, bei dem in einer oder mehreren, mindestens zwei, Stellungen (4) ein beweglicher optischer Datenträger (6) mittels einer Verschiebevorrichtung (8) zum Holen des optischen Trägers (6) aus einem Archiv (7) angeordnet ist, der mit mindestens einer Quelle (1) modulierter elektromagnetischer Strahlung und mit mindestens einem Fotoempfänger (3) optisch gekoppelt ist, d a d u r c h   g e k e n n z e i c h n e t , daß er eine Einheit (2) zur Umschaltung der modulierten elektromagnetischen Strahlung von der Quelle (1) modulierter elektromagnetischer Strahlung auf die optischen Datenträger (6) und von den optischen Datenträgern (6) auf den Fotoempfänger (3) in Abhängigkeit von der Adresse der Stellung (4), in der der betreffende optischen Datenträger (6) angeordnet ist, enthält.

2. Optischer Speicher nach Anspruch 1, d a - d u r c h   g e k e n n z e i c h n e t , daß die Einheit (2) zur Umschaltung der modulierten elektromagnetischen  Strahlung optisch gekoppelt einen in einem gleichen Abstand von den optischen Datenträgern (6) bei deren Anordnung in einer entsprechenden Stellung (4) liegenden drehbaren Lichtteiler (9) und eine drehbar samt dem Lichtteiler (9) ausgeführte Linse (11) aufweist.

3. Optischer Speicher nach Anspruch 2, d a d u r c h   g e k e n n z e i c h n e t , daß bei der zylindrischen Ausführung des um seine Achse rotierenden optischen Datenträgers (6) die Drehachse des Leichtteilers (9) parallel zur Drehachse des zylindrischen optischen Datenträgers (6) verläuft.

0293495

FIG. 1

0298495

FIG. 2

0293495

FIG. 3

0293495

FIG. 4

FIG. 5

**I. CLASSIFICATION OF SUBJECT MATTER** (if several classification symbols apply, indicate all) **6**

According to International Patent Classification (IPC) or to both National Classification and IPC

IPC$^4$    G 11 C 11/42

**II. FIELDS SEARCHED**

Minimum Documentation Searched 7

| Classification System | Classification Symbols |
|---|---|
| IPC$^4$ | G 11 C/42, 13/04, G 11 B 7/00, 7/24 |

Documentation Searched other than Minimum Documentation
to the Extent that such Documents are Included in the Fields Searched **8**

**III. DOCUMENTS CONSIDERED TO BE RELEVANT 9**

| Category * | Citation of Document, 11 with indication, where appropriate, of the relevant passages 12 | Relevant to Claim No. 13 |
|---|---|---|
| A | US, A, 4470137, (Tokyo Shibaura Denki Kabushiki Kaisha) 4 September 1984 (04.09.84) see column 3, lines 1-65, figure 1 | 1-3 |
| A | US, A, 4519061, (Eastman Kodak Company), 21 May 1985 (21.05.85), see column 2, lines 35-65, figure 1 | 1-3 |
| A | EP, B1, 0033052, (THOMSON-CSF) 28 December 1983, (28.12.83), see column 7, lines 57-65, column 8, lines 4-36, figures 3-5 | 1-2 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art.

"&" document member of the same patent family

**IV. CERTIFICATION**

| Date of the Actual Completion of the International Search | Date of Mailing of this International Search Report |
|---|---|
| 4 February 1988 (04.02.88) | 10 March 1988 (10.03.88) |
| International Searching Authority | Signature of Authorized Officer |
| ISA/SU | |

Form PCT/ISA/210 (second sheet) (January 1985)